# EUROPEAN PATENT APPLICATION

(11) **EP 2 056 338 A2**
(43) Date of publication of application: **06.05.2009**
(21) Application number: 08017659.7
(22) Date of filing: 08.10.2008
(51) Int. Cl.: H01L 21/00

(54) **Method and system supporting production of a semiconductor device using a plurality of fabrication processes**

(30) Priority: 12.10.2007 US 1214
(71) Applicant: Broadcom Corporation, Irvine CA 92617 (US)
(72) Inventor: Syaed, Masood, 92692 Mission Viejo (US)
(74) Representative: Jehle, Volker Armin

(57) **Abstract**

There is provided a tuning method for use by a semiconductor device capable of being fabricated using a plurality of fabrication processes comprising reading a fabrication identification included in the semiconductor device, associating the fabrication identification with one of the plurality of fabrication processes to determine an associated fabrication process used for fabrication of the semiconductor device, and tuning at least one parameter of the semiconductor device based on the associated fabrication process.

## Description

### BACKGROUND OF THE INVENTION

### 1. FIELD OF THE INVENTION

The present invention is generally in the field of electronic circuits and systems. More specifically, the present invention is in the field of semiconductor devices and fabrication.

### 2. BACKGROUND ART

Electronic devices and systems have become an essential staple of modern existence, utilized in virtually every aspect of life, from increasing personal communications options, to enhancing workplace productivity, and even expanding the definition of workplace. As products such as personal computers, mobile telephones, navigational systems, and hands free communications devices become more sophisticated and, perhaps counter intuitively, easier to use, our reliance upon them grows. Consequently, what once were considered tools of convenience are increasingly seen as resources of necessity, and that trend has continued strongly.

The combined effects of increasing device complexity and growing consumer demand places considerable strain on the businesses that deliver sophisticated electronic products to the marketplace. On one hand, high demand produces an attractive commercial environment for those enterprises, encouraging others to enter the marketplace and compete for consumer affections. The resulting competition among product providers makes managing production costs crucial to their continued competitiveness. At the same time, however, the increased complexity of the component devices and sub-systems on which these sophisticated electronic products rely almost compels specialization by the suppliers of those component elements. As a result, a provider of cellular telephones, for example, must typically form alliances with suppliers of key cellular telephone components, such as semiconductor device components, and those semiconductor device suppliers may in turn rely upon semiconductor fabrication facilities utilizing various fabrication processes to produce the semiconductor devices they supply.

For a supplier delivering a product that depends on upstream component fabrication, access to more than one fabrication source for an essential component may be desirable. Having more than one source for essential components presents multiple advantages. First, having a choice amongst alternative fabrication sources producing the same component gives a business leverage to minimize component costs, which may be essential to its own competitiveness. Secondly, reliance on more than one fabrication source makes a supplier less vulnerable to production failures by any single facility. In addition, reliance on more than one fabrication source increases available production capacity, in case of a sudden spike in demand.

Although access to more than one fabrication source provides several advantages, as described, it also poses challenges for a supplier seeking to deliver consistent product performance while incorporating components from distinct sources. The challenge can be particularly great for suppliers of radio frequency (RF) communication product components, for example, where even minor variations in component performance can deleteriously effect overall system performance. For instance, the performance of a cellular telephone may depend on the performance of a component sub-system, which may itself be dependent on the performance of a semiconductor device. Where an integrated circuit chip is produced using multiple fabrication processes, the chip supplier must compensate for small variations in performance of the chips produced by the different fabrication processes, in order to supply a consistent product to a cellular telephone provider.

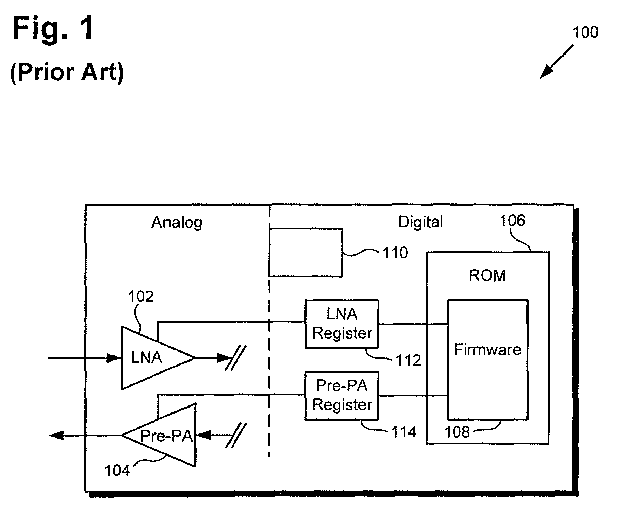

Conventional solutions for assuring consistent performance from semiconductor devices fabricated using multiple fabrication processes, for example, may include implementation of operating instructions that take into consideration variations in performance among the devices produced by the different fabrication processes. One such solution is presented in Figure 1, which shows a conventional semiconductor device, provided to support an RF communication system, for example.

Semiconductor device 100 comprises both analog and digital circuit elements, as shown in Figure 1. On the analog side, semiconductor device 100 includes low noise amplifier (LNA) 102 and pre-power amplifier (Pre-PA) 104. On the digital side, semiconductor device 100 includes read-only-memory (ROM) 106 storing firmware 108. Firmware 108 may be utilized to control the performance of semiconductor device 100 by determining values stored in registers supplying operational parameters to circuit elements. Such registers are represented on semiconductor device 100 by LNA register 112 and Pre-PA register 114, containing settings respectively for LNA 102 and Pre-PA 104. Also shown in Figure 1 is interface register 110, which has not been assigned a specific registry value in semiconductor device 100, and thus corresponds to a free register in the present conventional example. In Figure 1, LNA 102 is shown receiving an off chip input from an unspecified device, while Pre-PA 104 is shown providing an output to an unspecified off chip device. The broken lines to the right of LNA 102 and Pre-PA 104, respectively, indicate the presence of other circuit components present on semiconductor device 100, but not shown in Figure 1.

An advantage of the conventional solution shown in Figure 1 is that operating instructions programmed into firmware 108 provide control over the performance of semiconductor device 100. The conventional solution provides a common set of firmware instructions that represents something of a compromise among the alternative performance profiles resulting from the slightly varying fabrication processes used to produce semiconductor device 100. Therein lies a significant disadvantage of the conventional solution as well. Because semiconductor device 100 is tuned to provide a uniform level of performance achievable by chips fabricated using each fabrication process utilized by a different fabrication source, it is typically the spectrum of achievable performance parameters that determines the selected tuning values, rather than the optimum performance of a single version of semiconductor device 100, or the performance parameters most advantageous to end user performance of a system utilizing semiconductor device 100.

Thus, there is a need to overcome the drawbacks and deficiencies in the art to enable determination of tuning parameters for a semiconductor device according to the fabrication process used to produce it.

### SUMMARY OF THE INVENTION

A method and system supporting production of a semiconductor device using a plurality of fabrication processes, substantially as shown in and/or described in connection with at least one of the figures, as set forth more completely in the claims.

According to an aspect, a tuning method for use by a semiconductor device capable of being fabricated using a plurality of fabrication processes comprises:
reading by the semiconductor device, a fabrication identification included in the semiconductor device;
associating the fabrication identification with one of the plurality of fabrication processes to determine an associated fabrication process used for fabrication of the semiconductor device; and
tuning at least one parameter of the semiconductor device based on the associated fabrication process.

Advantageously, the tuning is performed by a firmware corresponding to the associated fabrication process.

Advantageously, the method further comprises: running a temperature compensation algorithm, the temperature compensation algorithm being selected by the semiconductor device according to the associated fabrication process.

Advantageously, the fabrication identification is in a register interfacing analog and digital portions of the semiconductor device.

Advantageously, the fabrication identification is in a read only memory (ROM) of the semiconductor device.

Advantageously, the semiconductor device is a radio frequency (RF) communication device.

Advantageously, the semiconductor device is utilized as a part of an electronic system, the electronic system being selected from the group consisting of a wired communications device, a wireless communications device, a cell phone, a switching device, a router, a repeater, a codec, a LAN, a WLAN, a Bluetooth enabled device, a digital camera, a digital audio player and/or recorder, a digital video player and/or recorder, a computer, a monitor, a television set, a satellite set top box, a cable modem, a digital automotive control system, a digitally-controlled home appliance, a printer, a copier, a digital audio or video receiver, an RF transceiver, a personal digital assistant (PDA), a digital game playing device, a digital testing and/or measuring device, a digital avionics device, a medical device, and a digitally-controlled medical equipment.

According to an aspect, a circuit is provided capable of being patterned on a semiconductor die using a plurality of fabrication processes, the circuit comprising:
a digital circuitry;
an analog circuitry;
a fabrication identification, wherein the fabrication associates the circuit with one of the plurality of fabrication processes used for fabrication of the circuit; and
an interface circuitry interfacing the digital circuitry with the analog circuitry, the interface circuitry for use by the digital circuitry to tune the analog circuitry based on the fabrication identification.

Advantageously, the fabrication identification is in the interface register.

Advantageously, the fabrication identification is in a read-only-memory ROM of the circuit.

Advantageously, the circuit is for use in a radio frequency (RF) communications system.

Advantageously, the circuit is utilized as a part of an electronic system, the electronic system being selected from the group consisting of a wired communications device, a wireless communications device, a cell phone, a switching device, a router, a repeater, a codec, a LAN, a WLAN, a Bluetooth enabled device, a digital camera, a digital audio player and/or recorder, a digital video player and/or recorder, a computer, a monitor, a television set, a satellite set top box, a cable modem, a digital automotive control system, a digitally-controlled home appliance, a printer, a copier, a digital audio or video receiver, an RF transceiver, a personal digital assistant (PDA), a digital game playing device, a digital testing and/or measuring device, a digital avionics device, a medical device, and a digitally-controlled medical equipment.

Advantageously, the circuit further comprises a read-only-memory (ROM) including a firmware, the firmware including a fabrication identification firmware corresponding to the associated fabrication process.

Advantageously, the fabrication identification firmware corresponding to the associated fabrication process determines settings for programmable parameters of the circuit.

Advantageously, the fabrication identification firmware corresponding to the associated fabrication process determines a temperature compensation algorithm for the circuit.

According to an aspect, a circuit is provided capable of being patterned on a semiconductor die using a plurality of fabrication processes, the circuit comprising:
a fabrication identification, wherein the fabrication associates the circuit with one of the plurality of fabrication processes used for fabrication of the circuit; and
a read-only-memory (ROM);
a fabrication identification firmware in the ROM, the fabrication identification firmware designed to read the fabrication identification and associate the fabrication identification with one of plurality of fabrication processes to determine an associated fabrication process, the fabrication identification firmware further designed to tune the circuit based on the associated fabrication process.

Advantageously, the fabrication identification firmware determines settings for programmable parameters of the circuit based on the associated fabrication process.

Advantageously, the fabrication identification firmware determines a temperature compensation algorithm for the circuit based on the associated fabrication process

Advantageously, the fabrication identification firmware determines a receiver level for the circuit based on the associated fabrication process.

Advantageously, the fabrication identification firmware determines a transmitter level for the circuit based on the associated fabrication process.

### BRIEF DESCRIPTION OF THE DRAWINGS

The features and advantages of the present invention will become more readily apparent to those ordinarily skilled in the art after reviewing the following detailed description and accompanying drawings, wherein:
Figure 1 shows a conventional semiconductor device;
Figure 2 shows a semiconductor device capable of being fabricated using a plurality of fabrication processes, according to on embodiment of the present invention;
Figure 3 is a flowchart presenting a tuning method for a semiconductor device capable of being fabricated using a plurality of fabrication processes, according to one embodiment of the present invention; and
Figure 4 is a diagram of an exemplary electronic system including an exemplary semiconductor device capable of being fabricated using a plurality of fabrication processes, in accordance with one or more embodiments of the present invention.

### DETAILED DESCRIPTION OF THE INVENTION

The present invention is directed to a method and system supporting production of a semiconductor device using a plurality of fabrication processes. Although the invention is described with respect to specific embodiments, the principles of the invention, as defined by the claims appended herein, can obviously be applied beyond the specifically described embodiments of the invention described herein. Moreover, in the description of the present invention, certain details have been left out in order to not obscure the inventive aspects of the invention. The details left out are within the knowledge of a person of ordinary skill in the art.

The drawings in the present application and their accompanying detailed description are directed to merely example embodiments of the invention. To maintain brevity, other embodiments of the invention, which use the principles of the present invention, are not specifically described in the present application and are not specifically illustrated by the present drawings. It should be borne in mind that, unless noted otherwise, like or corresponding elements among the figures may be indicated by like or corresponding reference numerals.

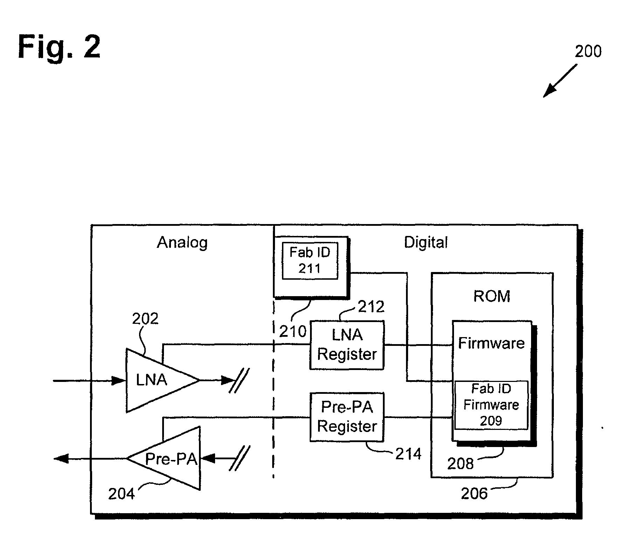

Figure 2 shows semiconductor device 200 capable of being fabricated using a plurality of fabrication processes, according to one embodiment of the present invention. It should be noted that Figure 2 is for the purpose of providing an overview, and elements shown in Figure 2 are conceptual representations of physical and electrical elements, and are thus not intended to show dimensions or relative sizes or scale.

Figure 2 shows semiconductor device 200 comprising both analog and digital circuit elements, analogous to semiconductor device 100, in Figure 1. Semiconductor device 200 includes low noise amplifier (LNA) 202 and pre-power amplifier (Pre-PA) 204, corresponding respectively to LNA 102 and Pre-PA 104, on semiconductor device 100. Also included on semiconductor device 200 are LNA register 212 and Pre-PA register 214, containing respective settings for LNA 202 and Pre-PA 204, corresponding respectively to LNA register 112 and Pre-PA 114, in Figure 1. Moreover, semiconductor device 200 includes read only memory (ROM) 206, corresponding to ROM 106, on semiconductor device 100.

In Figure 2, LNA 202 is shown receiving an off chip input from an unspecified device, while Pre-PA 204 is shown providing an output to an unspecified off chip device. The broken lines to the right of LNA 202 and Pre-PA 204, respectively, indicate the presence of other circuit components present on semiconductor device 200, but not shown in Figure 2. Semiconductor device 200 might be utilized in a cellular telephone, for example, in which implementation semiconductor device 200 might represent the "on chip" portion of a transceiver system. In that case LNA 202 may receive an input, as shown in Figure 2, from a transceiver duplexer, and the broken lines to the right of LNA 202 might indicate the presence of other receiver components. Moreover, in that instance, a signal from Pre-PA 204 may travel off semiconductor device 200 to a power amplifier, (not shown in Figure 2), while the broken lines to the right of Pre-PA 204 might indicate the presence of other transmitter components.

Also included in semiconductor device 200 of Figure 2, is fabrication identification or Fab ID 211 stored in interface register 210, and having no analogue in the conventional semiconductor device of Figure 1. Further distinguishing semiconductor device 200 from conventional devices is the inclusion of Fab ID firmware 209 in firmware 208 for supporting Fab ID 211. As was the case for semiconductor device 100 in Figure 1, in Figure 2, firmware 208 may be utilized to control the performance of semiconductor device 200 by determining values stored in registers supplying operational parameters to programmable circuit elements. Unlike conventional approaches, however, in the embodiment of Figure 2, those register values are determined according to the fabrication process used to produce semiconductor device 200 using Fab ID 211 and Fab ID firmware 209.

In effect, the performance of semiconductor device 200, in Figure 2, may be tuned or adjusted according to the fabrication process by which it was produced. As a result, semiconductor device 200 may deliver a performance optimized to a desired performance target, rather than compromised by limitations imposed by similar devices produced by alternative fabrication processes. That improvement over conventional devices is enabled in part by inclusion of Fab ID 211 in semiconductor device 200.

By including Fab ID 211, e.g., four bits having the permanent value of"0010", in semiconductor device 200, the present embodiment permits semiconductor device 200 to read Fab ID 211, associate Fab ID 211 with one of a plurality of fabrication processes to determine an associated fabrication process used for fabrication of semiconductor device 200, and to tune one or more parameters according to the associated fabrication process. In one embodiment, the fabricated process and its rules and parameters may be defined by fabrication labs or libraries provided by fabrication labs, such as TSMC (Taiwan Semiconductor Manufacturing Company), UMC (United Microelectronics Corporation), or other foundries. In one embodiment, a temperature compensation algorithm optimized to the fabrication process producing semiconductor device 200 may also be run, in which case the temperature compensation algorithm may be selected by semiconductor device 200, according to the fabrication process associated with Fab ID 211.

Although in the present embodiment, Fab ID 211 is represented as a four-bit registry entry on semiconductor device 200, in other embodiments Fab ID 211 may be encoded in a register using more, or fewer, bits. Alternatively, in one embodiment, Fab ID 211 is burned into a non-volatile memory, such as ROM 206, for example, or Fab ID 211 may be set by tying one or more bits, high or low, in interface register 210 while designing the circuits for semiconductor device 200. Furthermore, in other embodiments, semiconductor device 200 may correspond to devices other than semiconductor device 200, and may comprise any semiconductor device capable of having its performance tunably enhanced.

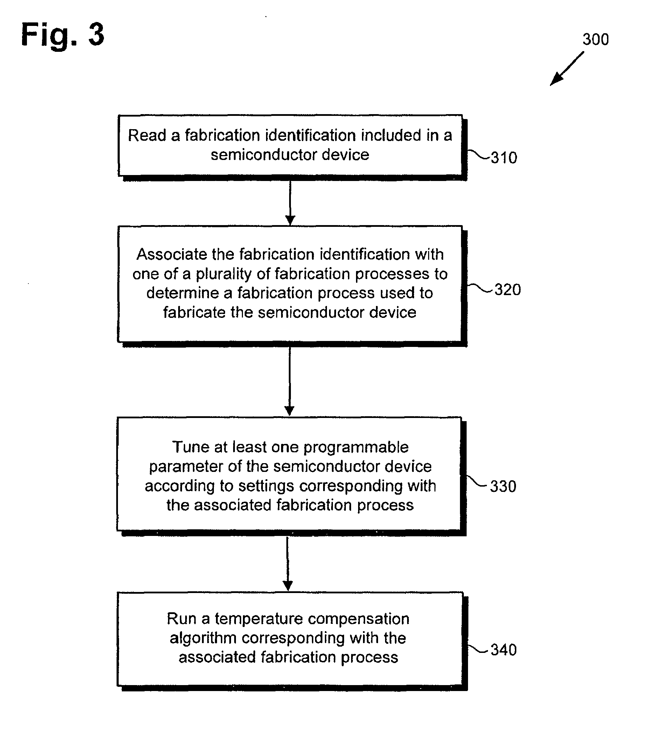

Turning now to Figure 3, Figure 3 shows flowchart 300 describing the steps, according to one embodiment of the present invention, of a tuning method for a semiconductor device capable of being fabricated using a plurality of fabrication processes. Certain details and features have been left out of flowchart 300 that are apparent to a person of ordinary skill in the art. For example, a step may comprise one or more substeps or may involve specialized equipment or materials, as known in the art. While steps 310 through 340 indicated in flowchart 300 are sufficient to describe one embodiment of the present invention, other embodiments of the invention may utilize steps different from those shown in flowchart 300.

Referring to the steps of flowchart 300 in Figure 3, in conjunction with Figure 2, step 310 of flowchart 300 comprises reading interface register 210 included in semiconductor device 200. In Figure 2, step 310 is shown by the connection between firmware 208 and interface register 210 in which Fab ID 211 is stored. As discussed in relation to Figure 2, in other embodiments Fab ID 211 may be recorded elsewhere for reading by semiconductor device 200, for example, Fab ID 211 may be stored in ROM 206. Reading Fab ID 211 provides a criterion allowing semiconductor device 200 to be distinguished from substantially matching devices made by a different fabrication process.

Continuing with step 320 of Figure 3, step 320 of flowchart 300 comprises associating Fab ID 211 with one of a plurality of fabrication processes to determine a fabrication process used to fabricate semiconductor device 200. Association of semiconductor device 200 with the fabrication process used to produce it enables determination of programmable parameters for adjusting the performance of semiconductor device 200 to a desired standard.

Step 330 of flowchart 300 comprises tuning at least one programmable parameter of semiconductor device 200 according to settings corresponding to the associated fabrication process. In the embodiment of Figure 2, step 330 is represented by the presence of Fab ID firmware 209 included in firmware 208. In that example, association of Fab ID 211 with one of a plurality of fabrication processes in step 320, allows selection of corresponding Fab ID firmware 209 retrieving programmable settings corresponding to the associated fabrication process. Continuing with the embodiment of Figure 2, where, for example, step 310 had read "0001" from Fab ID 211 rather than "0010" in interface register 210, tuning of programmable parameters could be determined by settings provided by Fab ID firmware 209, corresponding with the fabrication process used to produce semiconductor device 200.

Although in the embodiment shown in Figure 2, tuning step 330 is represented as being performed by Fab ID firmware 209, in another embodiment, associating a fabrication identification with a fabrication process may include designation of a programmable parameter database corresponding to the fabrication process. In that embodiment, tuning may be performed by a common firmware, such as firmware 108 in Figure 1, with appropriate importation of fabrication process specific parameter settings from the designated database, for example.

Continuing with step 340 of flowchart 300, step 340 comprises running a temperature compensation algorithm corresponding with the associated fabrication process. Just as different fabrication processes may produce subtlely distinct performance profiles that may be brought into alignment by the tuning of programmable parameters, those different fabrication processes my result in varying temperature response profiles among a family of semiconductor devices as well. Even where, for example, performance parameters of semiconductor devices produced by different fabrication processes are substantially identical, their temperature response may not be, so that performance stability may vary among those devices. Step 340 may be performed to address that possibility by applying a temperature compensation algorithm specific to the fabrication process used for production of the semiconductor device. Other performance parameters that can be tuned by Fab ID firmware 208 may include transmitter and receiver high and low dB levels in the analog portion of the semiconductor device 200.

As a result of the tuning method for a semiconductor device capable of being fabricated using a plurality of fabrication processes, described in the exemplary embodiments set forth in the present application and shown by flowchart 300 in Figure 3, a semiconductor device can be prepared for use and implemented.

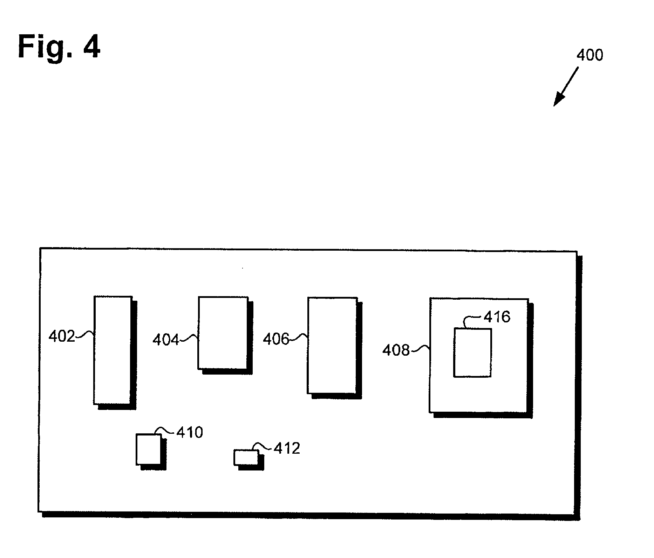

Figure 4 is a diagram of an exemplary electronic system including an exemplary semiconductor device capable of being fabricated using a plurality of fabrication processes, in accordance with one or more embodiments of the present invention. Electronic system 400 includes exemplary modules 402, 404, and 406, semiconductor device 408, discrete components 410 and 412, residing in and interconnected through electronic system 400, for example, through a circuit board. Semiconductor device 408, in Figure 4, includes circuit 416, which can be a microprocessor, for instance. Although in the present embodiment electronic system 400 is shown to include exemplary modules 402, 404, and 406, and discrete components 410 and 412, in addition to semiconductor device 408, in one embodiment electronic system 400 may be implemented as a System-on-a-Chip (SoC), for example.

As shown in Figure 4, modules 402, 404, and 406 are included in electronic system 400 and can each be, for example, a central processing unit (CPU), a graphics controller, a digital signal processor (DSP), an application specific integrated circuit (ASIC), a video processing module, an audio processing module, a radio frequency (RF) receiver, an RF transmitter, an image sensor module, a power control module, an electromechanical motor control module, or a field programmable gate array (FPGA), or any other kind of module utilized in modem electronic systems. Electronic system 400 can include a number of interconnects (not shown in Figure 4) for interconnecting modules 402, 404, and 406, discrete components 410 and 412, and semiconductor device 408. Also shown in Figure 4, discrete components 410 and 412 are included in electronic system 400 and can each be, for example, a discrete filter, such as one including a BAW or SAW filter or the like, a power amplifier or an operational amplifier, an additional semiconductor device, an antenna element, an inductor, a capacitor, or a resistor.

Electronic system 400 can be utilized in, for example, a wired communications device, a wireless communications device, a cell phone, a switching device, a router, a repeater, a codec, a LAN, a WLAN, a Bluetooth enabled device, a digital camera, a digital audio player and/or recorder, a digital video player and/or recorder, a computer, a monitor, a television set, a satellite set top box, a cable modem, a digital automotive control system, a digitally-controlled home appliance, a printer, a copier, a digital audio or video receiver, an RF transceiver, a personal digital assistant (PDA), a digital game playing device, a digital testing and/or measuring device, a digital avionics device, a medical device, or a digitally-controlled medical equipment, or in any other kind of system, device, component or module utilized in modem electronics applications.

Thus, the present application discloses a method and system supporting production of a semiconductor device using a plurality of fabrication processes. By having a semiconductor device read a fabrication identification recorded in itself, one embodiment of the present invention enables identification of the fabrication process by which the semiconductor device was produced, from among a plurality of possible alternatives. By further associating performance characteristics, including temperature response, for example, with an identified fabrication process, one embodiment of the present invention permits fabrication process specific tuning and performance management of a semiconductor device, advantageously improving adherence to desired performance specifications.

From the above description of the invention it is manifest that various techniques can be used for implementing the concepts of the present invention without departing from its scope. Moreover, while the invention has been described with specific reference to certain embodiments, a person of ordinary skill in the art would recognize that changes can be made in form and detail without departing from the spirit and the scope of the invention. The described embodiments are to be considered in all respects as illustrative and not restrictive. It should also be understood that the invention is not limited to the particular embodiments described herein, but is capable of many rearrangements, modifications, and substitutions without departing from the scope of the invention.

## Claims

1. A tuning method for use by a semiconductor device capable of being fabricated using a plurality of fabrication processes, the method comprising:
reading by the semiconductor device, a fabrication identification included in the semiconductor device;
associating the fabrication identification with one of the plurality of fabrication processes to determine an associated fabrication process used for fabrication of the semiconductor device; and
tuning at least one parameter of the semiconductor device based on the associated fabrication process.

2. The tuning method of claim 1, wherein the tuning is performed by a firmware corresponding to the associated fabrication process.

3. The tuning method of claim 1 further comprising: running a temperature compensation algorithm, the temperature compensation algorithm being selected by the semiconductor device according to the associated fabrication process.

4. The tuning method of claim 1, wherein the fabrication identification is in a register interfacing analog and digital portions of the semiconductor device.

5. The tuning method of claim 1, wherein the fabrication identification is in a read only memory (ROM) of the semiconductor device.

6. A circuit capable of being patterned on a semiconductor die using a plurality of fabrication processes, the circuit comprising:
a digital circuitry;
an analog circuitry;
a fabrication identification, wherein the fabrication associates the circuit with one of the plurality of fabrication processes used for fabrication of the circuit; and
an interface circuitry interfacing the digital circuitry with the analog circuitry, the interface circuitry for use by the digital circuitry to tune the analog circuitry based on the fabrication identification.

7. The circuit of claim 6, wherein the fabrication identification is in the interface register.

8. The circuit of claim 6, wherein the fabrication identification is in a read-only-memory ROM of the circuit.

9. The circuit of claim 6, wherein the circuit is for use in a radio frequency (RF) communications system.

10. A circuit capable of being patterned on a semiconductor die using a plurality of fabrication processes, the circuit comprising:
a fabrication identification, wherein the fabrication associates the circuit with one of the plurality of fabrication processes used for fabrication of the circuit; and
a read-only-memory (ROM);
a fabrication identification firmware in the ROM, the fabrication identification firmware designed to read the fabrication identification and associate the fabrication identification with one of plurality of fabrication processes to determine an associated fabrication process, the fabrication identification firmware further designed to tune the circuit based on the associated fabrication process.
